(19) **Europäisches Patentamt**

**European Patent Office**

**Office européen des brevets**

(11) Veröffentlichungsnummer: **0 257 329**
**A2**

(12) **EUROPÄISCHE PATENTANMELDUNG**

(21) Anmeldenummer: **87110951.8**

(22) Anmeldetag: **28.07.87**

(51) Int. Cl.⁴: **H05K 13/04**

(30) Priorität: **25.08.86 DE 3628849**

(43) Veröffentlichungstag der Anmeldung:
**02.03.88 Patentblatt 88/09**

(84) Benannte Vertragsstaaten:
**CH DE FR GB IT LI SE**

(71) Anmelder: **Siemens Aktiengesellschaft Berlin und München**
**Wittelsbacherplatz 2**
**D-8000 München 2(DE)**

(72) Erfinder: **Haller, Heinrich, Dipl.-Ing.**
**Saarwerderstrasse 17**
**D-4000 Düsseldorf 11(DE)**
Erfinder: **Heimüller, Hans-Jost**
**Am Schafgarten 9**
**D-6724 Dudenhofen(DE)**

(54) **Vorrichtung zum Beschneiden von stiftartigen Anschlusselementen eines elektrischen Bauelementes.**

(57) Anschlußelemente (9) von elektrischen Bauelementen (8) werden zunächst auseinandergespreizt und mittels Greiffingern (15) eines Handhabungsroboters auf einen definierten Abstand zusammengedrückt. Das Auseinanderspreizen und das Beschneiden der Anschlußelemente erfolgt in einem Vorgang durch einen kombinierten Spreizdorn (3) und Schnittstempel (1).

## FIG 5

EP 0 257 329 A2

# Vorrichtung zum Beschneiden von stiftartigen Anschlußelementen eines elektrischen Bauelementes

Die Erfindung bezieht sich auf eine Vorrichtung zur Durchführung eines Verfahrens zum automatisierten Einsetzen von in die gleiche Richtung weisenden Anschlußelementen eines elektrischen Bauelementes in Öffnungen eines Trägerteiles mittels eines Greifers, der das Bauelement an seinen Anschlußelementen in der Nähe von deren freien Enden ergreift, gemäß der deutschen Offenlegungsschrift 35 13 679. wonach die Anschlußelemente vor dem Greifvorgang leicht auseinandergespreizt angeordnet werden und wonach der Greifer die Anschlußelemente von außen umgreift und deren freie Enden auf ein gewünschtes Maß zusammendrückt.

Zum Beschneiden von z.B. einseitig gegurteten Bauelementen war es bisher üblich, die Anschlußelemente mittels einer Schnittplatte und eines Schnittstempels auf eine gewünschte Länge zu beschneiden. Das Auseinanderspreizen der Anschlußelemente müßte bei einem derartig beschnittenen Bauelement in einer nachfolgend angeordneten Station erfolgen.

Der Erfindung liegt die Aufgabe zugrunde, das Beschneiden und Auseinanderspreizen der Anschlußelemente zu vereinfachen.

Diese Aufgabe wird durch die Erfindung gemäß Anspruch 1 gelöst. Danach sind die Beschneide- und die Spreizeinrichtung zu einer Baueinheit zusammengefaßt. Beide Vorgänge werden in einem Arbeitsgang durchgeführt. Eine Transporteinrichtung für die beschnittenen Bauelemente zu einer Spreizstation entfällt. Die Bauelemente können vielmehr direkt von der kombinierten Beschneide-und Spreizstation mittels des Greifers entnommen werden. Durch die Zusammenfassung der Funktionen in einem Werkzeug wird auch die Baubreite der Einrichtung entsprechend gering. Es ist üblich, die einseitig an den abzuschneidenden Enden der Anschlußelemente gegurteten Bauelemente über eine Stachelwalze laufen zu lassen, in deren vorderster Position das Bauelement beschnitten und dem Greifer übergeben wird. Da die kombinierte Station nicht breiter wird als eine einfache Beschneidestation wird die Baubreite der gesamten Zuführeinrichtung nicht vergrößert. Dies ist besonders wichtig, da eine Vielzahl von derartigen Zuführeinrichtungen dem Greifbereich eines Bestückungsroboters zugeordnet wird. Dabei ist es besonders wichtig, die Baubreite gering zu halten, um eine möglichst große Anzahl unterschiedlicher Bauelemente bereithalten zu können. Die Vorrichtung kann durch Einsetzen von Schnittstempeln mit unterschiedlich breiten Spreizdornen verschiedenen Bauelementtypen mit unterschiedlich beabstandeten Anschlußelementen angepaßt werden. Aus diesem Grunde wird der Schnittstempel leicht austauschbar angeordnet. Bei Gelegenheit des Auswechselns können auch die Schnittflächen des Schnittstempels nachgeschliffen werden.

Vorteilhafte Weiterbildungen der Erfindung sind in den Ansprüchen 2 bis 5 gekennzeichnet:

Durch die Weiterbildung nach Anspruch 2 kann der Schnittstempel zwischen der Schnittplatte und der Stützplatte beim Schneidvorgang geführt werden, wobei sich eine großflächige Abstützung an der Stützplatte ergibt.

Die Weiterbildung nach Anspruch 3 ermöglicht das Ausweichen der abgeschnittenen Anschlußelemente in der Schnitt richtung.

Durch die Weiterbildung nach Anspruch 4 ist es möglich, die Anschlußelemente bereits vor dem Spreizen mit einer Kraft einzuklemmen, die groß genug ist, ein Verbiegen der Anschlußelemente in der Stempelrichtung zu verhindern, die aber das seitliche Ausweichen der Anschlußelemente beim Spreizen nicht zu stark erschwert. Nach dem Abschneiden werden die Anschlußelemente des Bauelementes zwischen dem Niederhalter und der Schnittplatte sicher gehalten, was eine genaue Übergabeposition für den Greifer ermöglicht. Durch die Begrenzung der Klemmkraft kann das Bauelement ohne Zurückziehen des Niederhalters herausgezogen werden, was den Funktionsablauf vereinfacht.

Die Weiterbildung nach Anspruch 5 ermöglicht die gemeinsame Bearbeitung der Stirnseiten der Spreiz-und Stützdorne. Diese können beispielsweise nach allen Seiten angefast werden, so daß sich entsprechende Auflaufschrägen bilden.

Im folgenden wird die Erfindung anhand eines in der Zeichnung dargestellten Ausführungsbeispieles näher erläutert.

Es zeigen:

Fig. 1 in perspektivischer Darstellung einen Schnittstempel mit einem Spreizdorn und eine Stützplatte einer Vorrichtung zum Beschneiden und Auseinanderspreizen von Anschlußelementen elektrischer Bauelemente,

Fig. 2 einen schematisierten Schnitt durch die Vorrichtung mit den Teilen nach Fig. 1 und einem gegurteten elektrischen Bauelement,

Fig. 3 die Vorrichtung nach Fig. 2 in einer seitlichen Darstellung,

Fig. 4 die Vorrichtung nach Fig. 2 in einer anderen Seitendarstellung und in einer anderen Funktionsphase,

Fig. 5 einen Schnitt durch die Vorrichtung nach Fig. 4,

Fig. 6 die Vorrichtung nach Fig. 4 mit einem Teil eines Greifers zum Greifen der Bauelemente.

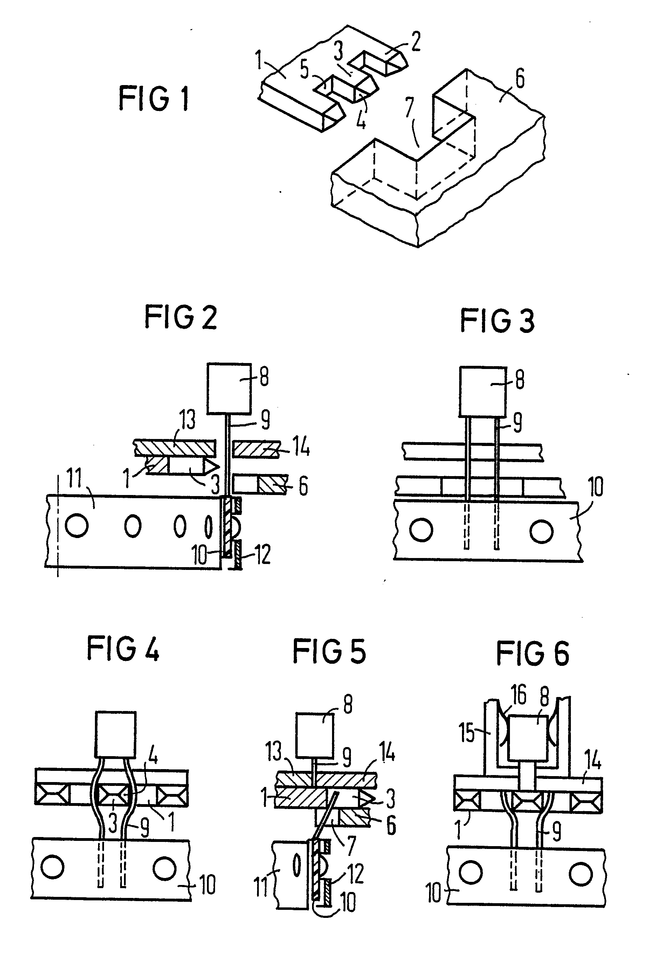

Nach Fig. 1 ist ein Schnittstempel 1 mit gabelartigen Vorsprüngen ausgebildet, von denen die äußeren als Stützdorne 2 und der mittlere als Spreizdorn 3 dienen. Der Spreizdorn 3 weist stirnseitig seitliche keilförmige Spreizflächen 4 für Anschlußelemente von elektrischen Bauelementen auf. Zu beiden Seiten des Spreizdorns 3 ist der Schnittstempel 1 mit rechtwinkelig zum Spreizdorn 4 verlaufenden Schnittflächen 5 zum Beschneiden der Anschlußelemente versehen. In einer Ebene unmittelbar unterhalb des Schnittstempels 1 ist eine Stützplatte 6 angeordnet, auf der sich die Stützdorne 2 nach Erreichen der Stützplatte 6 abstützen. Die Stützplatte 6 weist eine rechteckige Freimachung 7 für die abgeschnittenen Enden der Anschlußelemente auf.

Nach den Fig. 2 und 3 sind Bauelemente 8 mit zueinander parallelen, in die gleiche Richtung weisenen stiftartigen Anschlußelementen 9 versehen, deren freie Enden in einem gelochten Gurt 10 gehalten sind. Dieser ist über eine Stachelwalze 11 geführt, die entsprechend der Lochteilung des Gurtes 10 schrittweise weitergedreht werden kann. Auf der Außenseite des Gurtes 10 ist ein Leitblech 12 zur Stabilisierung des Gurtes 10 angeordnet.

Oberhalb der Stachelwalze 11 ist der Schnittstempel 1 angeordnet, der zur Mittelachse der Stachelwalze hin gerichtet ist. Er ist in deren radialer Richtung verschiebbar und weist mit der Spitze seines Spreizdornes 3 in Richtung der Anschlußelemente 9. Oberhalb des Schnittstempels 1 ist ein plattenförmiger Niederhalter 13 ange ordnet, der in die gleiche Richtung verschiebbar ist. Auf der gegenüberliegenden Seite der Anschlußelemente 9 befindet sich in Höhe des Niederhalters 13 eine Schnittplatte 14, deren Unterseite mit der Oberseite des Schnittstempels 1 fluchtet. Die Stützplatte 6 befindet sich unterhalb der Schnittplatte 14 und weist zu dieser einen Abstand von der Dicke des Schnittstempels 1 auf.

Nach den Fig. 4 und 5 ist der Schnittstempel 1 in Richtung der Schnittplatte 9 verschoben, wobei sich der Spreizdorn 3 mit seinen Spreizflächen 4 zwischen die Anschlußelemente 9 etwa in der Mitte zwischen dem Körper des Bauelementes 8 und dem Gurt 10 geschoben hat. Da die Breite des Spreizdornes 3 größer ist als der Abstand zwischen den Anschlußelementen 9, werden diese auseinandergedrückt. Zuvor hat bereits der gefederte Niederhalter 13 auf die Anschlußelemente 9 oberhalb des Schnittstempels 1 aufgesetzt und gegen die Schnittplatte 14 gedrückt. Der Schnittstempel 1 ist über die Spreizposition hinaus so weit vorgeschoben, daß er die Schnittplatte 14 überlappt. Dadurch sind die überstehenden Abschnitte der Anschlußelemente 9 abgeschert und in die Freimachung 7 der Stützplatte 6 ausgelenkt.

In dieser Stellung wird das Bauelement 8 mittels des Niederhalters 13 festgehalten und kann nach Fig. 6 von einem Greifer erfaßt werden. Dieser ergreift mit seinen Greiffingern 15 die Anschlußelemente 9 von außen her und biegt sie auf ihren Sollabstand zusammen. An den Greiffingern 15 sind außerdem Klemmfedern 16 angebracht, die den Körper des Bauelementes 8 federnd einklemmen. Das Bauelement 8 kann nun aus der Vorrichtung entfernt und auf eine zu bestückende Leiterplatte aufgesetzt werden.

## Ansprüche

1. Vorrichtung zur Durchführung eines Verfahrens zum automatisierten Einsetzen von in die gleiche Richtung weisenden Anschlußelementen (9) eines elektrischen Bauelementes (8) in Öffnungen eines Trägerteiles mittels eines Greifers, der das Bauelement (8) an seinen Anschlußelementen (9) in der Nähe von deren freien Enden ergreift, wobei die Anschlußelemente (9) vor dem Greifvorgang leicht auseinandergespreizt angeordnet werden und der Greifer die Anschlußelemente (9) von außen umgreift und deren freie Enden auf ein gewünschtes Maß zusammendrückt, **dadurch gekennzeichnet,** daß für das Spreizen der Anschlußelemente (9) von zweipoligen Bauelementen (8) ein senkrecht zu diesen und zwischen diese verschiebbarer Spreizdorn (3) mit keilförmig zur Verschieberichtung verlaufenden Spreizflächen (4) vorgesehen ist und daß der Spreizdorn (3) als Vorsprung an einem Schnittstempel (1) ausgebildet ist, der gegen eine feststehende Schnittplatte (14) verschiebbar ist, die auf der dem Bauelementkörper zugewandten Seite des Schnittstempels (1) angeordnet ist.

2. Vorrichtung nach Anspruch 1, **dadurch gekennzeichnet,** daß der Schnittstempel (1) seitlich parallel zum Spreizdorn (3) vorspringende Stützdorne (2) aufweist, die zwischen der Schnittplatte (14) und einer sich parallel zu dieser erstreckenden Stützplatte (6) geführt sind.

3. Vorrichtung nach Anspruch 2, **dadurch gekennzeichnet,** daß die Stützplatte (6) im Bereich der Anschlußelemente (9) eine Freimachung für die abgeschnittenen Enden der Anschlußelemente (9) aufweist.

4. Vorrichtung nach Anspruch 1, 2 oder 3, **dadurch gekennzeichnet,** daß ein eine geringe Andruckkraft aufweisender Niederhalter (13) zum Verklemmen der Anschlußelemente (9) mit der Schnittplatte (14) vorgesehen ist und daß die Spreizflächen (4) beim Auftreffen auf die Anschlußelemente (9) gegenüber dem Niederhalter (13) nacheilend ausgebildet sind.

5. Vorrichtung nach einem der vorhergehenden Ansprüche,

**dadurch gekennzeichnet,**

daß der Spreizdorn (3) und die Stützdorne (2) gleich lang ausgebildet sind.

4

**FIG 1**

**FIG 2**

**FIG 3**

**FIG 4**

**FIG 5**

**FIG 6**